# FASCICULE DE BREVET EUROPEEN

(11) **EP 3 866 341 B1**
(45) Date de publication et mention de la délivrance du brevet: **27.08.2025**
(21) Numéro de dépôt: 21150586.2
(22) Date de dépôt: 07.01.2021
(51) Int. Cl.: H03K 5/00

(54) **DISTRIBUTION ET CALIBRATION DE SIGNAUX SYNCHRONISÉS À TRAVERS UN CIRCUIT INTÉGRÉ OBTENU PAR PHOTO-RÉPÉTITION**
VERTEILUNG UND KALIBRIERUNG VON SYNCHRONISIERTEN SIGNALEN DURCH EINE INTEGRIERTE SCHALTUNG, DIE DURCH FOTOWIEDERHOLUNG ERHALTEN WIRD
DISTRIBUTION AND CALIBRATION OF SYNCHRONISED SIGNALS THROUGH AN INTEGRATED CIRCUIT OBTAINED BY PHOTO-REPETITION

(30) Priorité: 11.02.2020 FR 2001341
(43) Date de publication de la demande: 18.08.2021
(73) Titulaire: Pyxalis, 38430 Moirans (FR)
(72) Inventeur: BRESSON, Nicolas, 38000 GRENOBLE (FR)
(74) Mandataire: Atout PI Laplace

(56) Documents cités:
- DE-C1- 19 510 038
- FR-A1- 2 932 336
- US-B1- 6 774 694

## Description

### Champ d'application

L'invention concerne les circuits intégrés de grande dimension à motifs juxtaposés répétitifs, produits par exposition partielle répétée d'un même motif dans plusieurs zones d'un même substrat.

Cette technique de réalisation est parfois appelée technique de "stitching" ; elle consiste à utiliser lors d'une étape d'exposition photo-lithographique d'un substrat de circuit intégré un même masque définissant le motif à reproduire, masque qui est décalé successivement d'une zone du substrat à une autre zone adjacente, au cours de sous-étapes d'exposition. L'étape de photolithographie constituée par cette succession de sous-étapes peut être complétée par d'autres sous-étapes d'exposition de zones supplémentaires correspondant à des motifs différents, donc exposées à travers un ou plusieurs masques différents. L'étape de photolithographie est par exemple une étape de définition d'un motif de conducteurs dans une couche conductrice déposée sur le substrat. D'autres étapes de photolithographie sont effectuées pour la fabrication du circuit intégré, et pour chacune d'elles on va également procéder par « stitching », donc par exposition répétée d'un même motif dans des zones adjacentes ; on aboutit, à la fin de toutes les étapes de photolithographie et à la fin des traitements physiques ou chimiques associés, à un circuit intégré dont certaines zones, adjacentes les unes aux autres, sont rigoureusement identiques entre elles.

### Problème soulevé

Dans des circuits intégrés de large taille (quelques centimètres) et fonctionnant à des fréquences suffisamment élevées, la synchronisation des signaux de commandes généralement et du signal d'horloge spécifiquement présentent un défi technologique à résoudre pour assurer le bon fonctionnement de l'ensemble. En effet, un signal généré par un circuit séquenceur est propagé le long du circuit intégré obtenu par photo-répétition via une ligne conductrice horizontale pour être distribué aux différents circuits partiels photo-répétés composant le circuit intégré. Ainsi le délai de propagation du signal de contrôle entre le circuit séquenceur et le circuit partiel le plus éloigné est supérieur à celui propagé vers le circuit partiel le plus proche.

Dans le cas de la propagation d'un signal horloge, cette différence de délai de propagation engendre un problème de désynchronisation entre les différents circuits partiels surtout à haute fréquence de fonctionnement. Cette limitation est appelée en anglais « clock skew ». Dans les circuits électroniques numériques, résoudre ce problème de déphasage entre des signaux de commande régissant le fonctionnement de différents circuits partiels est fondamental pour assurer le bon fonctionnement de l'ensemble du circuit intégré à des fréquences élevées. Pour des circuits de plusieurs centimètres de côté, le décalage peut être de plusieurs dizaines de nanosecondes, ce qui n'est pas compatible avec des cadences de fonctionnement de plusieurs dizaines de mégahertz.

D'autres sources de désynchronisation des signaux de commande dans les circuits intégrés sont à retenir en plus de la différence de longueur de trajet parcouru par le signal pour atteindre un circuit partiel. D'ailleurs, la variabilité du procédé de fabrication des circuits intégrés engendre des différences structurelles à l'échelle des composants d'un circuit partiel à un autre. A titre d'exemple, les caractéristiques suivantes peuvent être impactées par la variabilité du procédé de fabrication microélectronique : l'épaisseur de l'oxyde de la grille d'un transistor, le dopage du substrat ou encore la largeur d'une connexion métallique.

L'impact de cette variabilité se manifeste à travers une différence dans la performance des composants d'un circuit partiel à un autre ce qui engendre une désynchronisation entre les signaux de commande pour chaque circuit partiel. Le même phénomène est aussi causé par un gradient de température à travers le circuit intégré et la variation de la performance des composants d'un circuit partiel à un autre selon ce gradient de température.

Ainsi, il existe un besoin pour réduire au maximum la désynchronisation des signaux de commande distribués dans des circuits intégrés de grande dimension réalisée par photo-répétition de plusieurs circuits partiels identiques les uns aux autres pour assurer un bon fonctionnement de l'ensemble à des fréquences suffisamment hautes.

### Art antérieur/ Restrictions de l'état de l'art

La demande de brevet EP 2 980 992 décrit un circuit intégré de grande taille réalisé par photo-répétition de plusieurs motifs partiels identiques les uns aux autres. Chaque circuit partiel du circuit intégré contient un circuit de compensation de délai à sorties multiples pour fournir un signal d'horloge local à chaque circuit partiel de façon synchronisé. La limite de la solution technique présentée dans EP 2 980 992 est son manque de robustesse par rapport à une variabilité en procédés de fabrication microélectronique et aussi par rapport à un gradient de température à travers le circuit intégré. Cette solution ne tient pas compte de l'ensemble des sources possibles de désynchronisation des signaux de commande citées précédemment. Il est également cité le document de brevet US 6774694 B1 qui divulgue un vernier de synchronisation pour optimiser la propagation du signala en maximisant la précision de synchronisation dudit signala en sélectionnant des prises d'étalonnage à partir de plusieurs lignes de délai.

De plus, la solution proposée ne permet pas de détecter et corriger l'état d'évolution de la désynchronisation des signaux de commande au cours du temps.

### Réponse au problème et apport solution

Pour pallier les limitations des solutions existantes en ce qui concerne la synchronisation des signaux de commandes dans les circuits intégrés réalisés par photo répétition, l'invention propose l'intégration d'un circuit de synchronisation de signaux de commande (ou signal d'horloge) dans chaque circuit partiel générant un signal de commande local pour gérer le fonctionnement du circuit partiel. Les circuits de synchronisation sont connectés à un circuit de calibration global mesurant le déphasage entre les signaux entre chaque couple de signaux reçus sur deux entrées respectives. Le signal de mesure étant destiné à piloter des composants d'insertion de délai programmables implémentés dans chaque circuit de synchronisation de chaque circuit partiel.

Cette solution permet de réduire le déphasage de plusieurs dizaines de nanosecondes à une centaine de picosecondes offrant une synchronisation optimale entre les signaux qui pilotent les différents circuits partiels. Elle présente en plus l'avantage de mesurer et corriger le déphasage pour une synchronisation qui tient en compte de la distribution spatiale des circuits partiels, de la variabilité des procédés de fabrication à travers le circuit intégré et du gradient spatio-temporel de la température.

### L'invention a pour objet un système sur puce comprenant :

un circuit intégré formé de N motifs adjacents tous identiques correspondant à N circuits partiels identiques adjacents de rang i = 1 à i = N dans l'ordre de succession des circuits partiels. Le circuit intégré nécessite pour son fonctionnement un signal maître reçu sur un circuit partiel de rang 1 et transmis en cascade d'un circuit partiel de rang i au circuit partiel de rang i+1 par une ligne conductrice principale dans chaque circuit partiel. Chaque circuit partiel de rang i comprend :
- un premier circuit de compensation de délai dont l'entrée est connectée à la ligne conductrice principale, le premier circuit de compensation de délai établissant un premier retard de propagation entre son entrée et sa sortie ;
- un premier composant d'insertion de délai programmable en série avec le premier circuit de compensation de délai ;
- un second composant d'insertion de délai programmable en série avec le premier composant d'insertion de délai programmable ;
- un second circuit de compensation de délai connecté à la sortie du second composant d'insertion de délai programmable, le second circuit de compensation de délai établissant un second retard de propagation entre son entrée et sa sortie ;
- N lignes conductrices de rang j=1 à j=N tel que la ligne de rang j du circuit partiel de rang i est connectée à la ligne de rang j du circuit partiel de rang i+1,
la ligne conductrice de rang j=i du circuit partiel de rang i étant connectée à la sortie du second circuit de compensation de délai du circuit partiel de rang i.

Le circuit intégré comprend en outre un circuit de calibration à N entrées reliées respectivement aux N lignes conductrices, configuré pour générer un signal de mesure du déphasage entre chaque couple de signaux reçus sur deux entrées respectives du circuit de calibration. De plus, le signal de mesure est destiné à piloter chaque composant d'insertion de délai programmable de chaque circuit partiel.

La sortie du premier composant d'insertion de délai programmable du circuit partiel de rang i fournissant ainsi un signal local pour ce circuit partiel.

Selon un aspect particulier de l'invention, le signal maître est un signal d'horloge général et le signal local issu du premier composant d'insertion de délai programmable de rang i est un signal d'horloge locale pour le circuit partiel de rang i.

Selon un aspect particulier de l'invention, le délai de propagation à travers le premier circuit de compensation de délai est égal au délai de propagation à travers le second circuit de compensation de délai.

Selon un aspect particulier de l'invention, le système sur puce comprend notamment un convertisseur analogique-numérique pour convertir le signal de mesure de déphasage en signal numérique et un circuit de programmation connecté à la sortie du convertisseur analogique-numérique pour commander les composants d'insertion de délai programmables dans chaque circuit partiel de rang i.

Selon un aspect particulier de l'invention, le circuit de calibration comprend :

un premier multiplexeur de calibration à N entrées reliées respectivement aux N entrées du circuit de calibration, un second multiplexeur de calibration à N entrées reliées respectivement aux N entrées du circuit de calibration et un circuit logique assurant la fonction OU EXCLUSIF à deux entrées reliées respectivement aux sorties des multiplexeurs de calibration.

De plus, le circuit de calibration comprend aussi, un élément capacitif entre la sortie du circuit logique et la masse électrique, une source de courant pour alimenter le circuit de calibration, un commutateur d'activation contrôlé par la sortie du circuit logique et un commutateur de réinitialisation connecté en parallèle à l'élément capacitif.

Selon un aspect particulier de l'invention, le premier circuit de compensation de délai d'un circuit partiel de rang i comprend une première ligne conductrice de compensation à N sorties successives de rang j = 1 à N, reliée à la ligne principale et un premier multiplexeur à N entrées de rang j = 1 à N reliées respectivement à chacune des N sorties de la première ligne conductrice de compensation et à une sortie reliée à la sortie du premier circuit de compensation de délai.

D'autre part, le second circuit de compensation de délai d'un circuit partiel de rang i comprend une seconde ligne conductrice de compensation à N sorties successives de rang j = 1 à N, reliée à la sortie du second composant d'insertion de délai programmable. Il comprend notamment un second multiplexeur à N entrées de rang j = 1 à N reliées respectivement à chacune des N sorties de la seconde ligne conductrice de compensation et à une sortie reliée à la sortie du second circuit de compensation de délai.

Selon un aspect particulier de l'invention, le premier multiplexeur du circuit partiel de rang i est configuré pour sélectionner la sortie de rang j=i parmi les N sorties de la première ligne de compensation à partir d'un premier signal de contrôle. Le second multiplexeur du circuit partiel de rang i est configuré pour sélectionner la sortie de rang i parmi les N sorties de la seconde ligne de compensation à partir d'un second signal de contrôle.

Selon un aspect particulier de l'invention, au moins un amplificateur tampon est inséré dans la ligne principale. De plus, un amplificateur tampon identique respectif est inséré dans la première ligne de compensation de délai entre chacune de ses sorties et la sortie de rang immédiatement suivant de la ligne. D'autre part, un amplificateur tampon identique respectif est inséré dans la seconde ligne de compensation de délai entre chacune de ses sorties et la sortie de rang immédiatement suivant de la ligne.

Selon un aspect particulier de l'invention, chaque circuit partiel de rang i comprend un circuit d'incrémentation d'une unité pour recevoir les signaux de contrôle des circuits multiplexeurs du circuit partiel de rang i, incrémenter d'une unité le rang de l'entrée sélectionnée et propager le signal de commande incrémenté vers les circuits multiplexeurs du circuit partiel de rang i+1.

Selon un aspect particulier de l'invention, les circuits partiels identiques adjacents sont réalisés au moyen d'une succession d'expositions photo-lithographiques d'un même masque, décalées spatialement.

D'autres caractéristiques et avantages de la présente invention apparaîtront mieux à la lecture de la description qui suit en relation aux dessins annexés suivants :
[Fig. 1] représente un schéma fonctionnel d'un système sur puce incluant un circuit intégré obtenu par photo répétition de plusieurs motifs partiels identiques selon l'invention.
[Fig. 2] représente un schéma fonctionnel de l'implémentation de la solution de synchronisation selon un premier mode de réalisation de l'invention.
[Fig. 3] représente un schéma fonctionnel de l'implémentation de la solution de synchronisation selon un second mode de réalisation de l'invention.
[Fig. 4] représente un schéma électrique des circuits de synchronisation obtenus par photo-répétition.
[Fig. 5] représente un exemple de schéma électrique du circuit de calibration.
[Fig. 6] représente un schéma de l'implémentation de la solution de synchronisation avec un exemple de commande des multiplexeurs des circuits de synchronisation.
[Fig. 7] représente un schéma électrique d'un circuit de synchronisation partiel incluant des amplificateurs tampons.

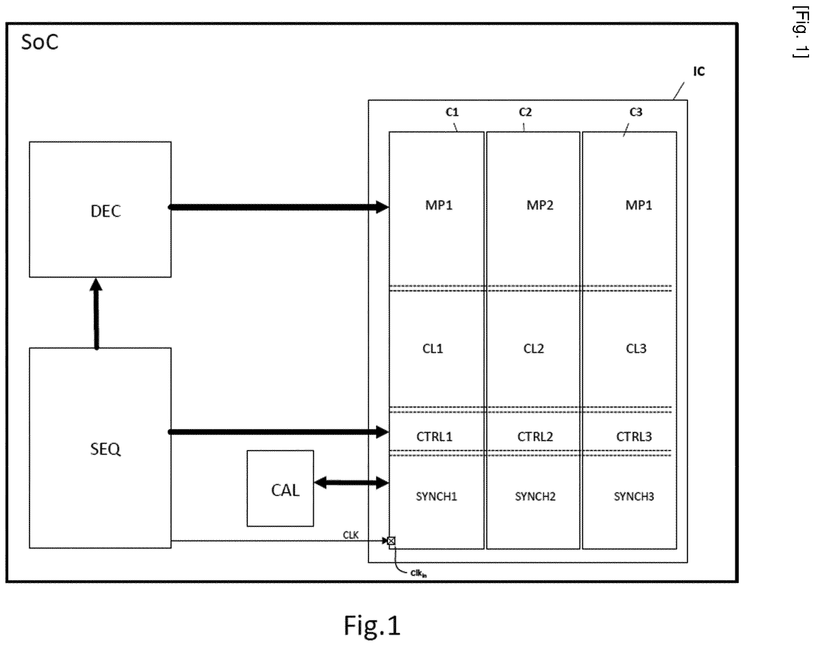

Pour illustrer l'invention, la figure 1 représente un schéma fonctionnel d'un exemple d'un système sur puce SoC incluant un circuit intégré IC obtenu par photo répétition de plusieurs motifs partiels identiques. Par exemple, le système sur puce décrit à la figure 1 peut être utilisé pour implémenter un capteur d'image. Plus généralement, il est compatible de tout type d'application qui nécessite la répétition de plusieurs motifs partiels identiques. Le système SoC comporte les éléments suivants.

Un circuit intégré IC obtenu par la juxtaposition de trois circuits partiels identiques C1 C2 C3 est réalisé par photo répétition. La figure 1 représente un exemple de trois circuits partiels mais la structure est généralisable pour N circuits partiels. Des liaisons conductrices sont établies entre les circuits adjacents par simple abutement d'un circuit partiel avec un autre identique circuit adjacent.

Dans le cas du capteur d'image représenté à la figure 1, chaque circuit partiel comprend les éléments suivants : une matrice de pixels MP1, MP2, MP3 pour assurer la capture des images par effet de conversion photoélectrique ; un circuit de lecture CL1, CL2, CL3 pour traiter les signaux générés par la matrice de pixel MP1,MP2,MP3 ;un circuit de commande numérique pour générer des signaux de commande locaux au circuit de lecture CTRL1,CTRL2,CTRL3 ; et un circuit de synchronisation SYNCH1,SYNCH2,SYNCH3 servant à réduire la désynchronisation des signaux de contrôles propagés dans l'ensemble du circuit intégré IC et commandant le fonctionnement de chacun des circuits partiels C1, C2 et C3. Dans ce qui suit nous allons traiter le cas du signal d'horloge Clk à titre d'exemple. Cependant la solution reste applicable pour tout signal nécessitant une synchronisation lors de sa distribution dans les circuits partiels identiques formant le circuit intégré IC.

Le système sur puce SoC comprend par ailleurs d'autres circuits électroniques non photo-répétés qui interagissent entre eux et avec le circuit intégré réalisé par photo-répétition IC. Il comprend notamment un circuit séquenceur général SEQ destiné à produire des signaux de commande pour les circuits partiels et notamment le signal d'horloge maître CLK qui sert de référence générale pour le déroulement des séquences de fonctionnement du capteur. Un autre circuit DEC comporte un décodeur de rangées pour l'adressage successif des lignes de la matrice lors des opérations de lecture des signaux issus des pixels. Ce décodeur adresse simultanément les lignes de même rang des matrices MP des trois circuits partiels. Cette organisation générale de la puce n'est donnée qu'à titre d'exemple non limitatif, l'invention étant applicable quels que soient les circuits de la puce à partir du moment où on a besoin de contrôler étroitement la synchronisation des fronts de signaux d'horloge utilisés dans les différents circuits partiels identiques, ou la synchronisation d'autres signaux de commande utilisés dans les circuits partiels. Dans cette organisation, comme cela est bien connu pour des circuits formés par photo-répétition, les circuits partiels sont connectés entre eux c'est-à-dire qu'un conducteur arrivant jusqu'à un bord latéral droit d'un circuit partiel est en contact direct avec un conducteur partant au même endroit du bord latéral gauche du circuit immédiatement adjacent de rang suivant. Ainsi, par exemple, un conducteur de ligne réunissant les pixels d'une ligne d'une matrice MP est en continuité avec un conducteur de ligne des matrices MP des autres circuits partiels.

De plus, un circuit de calibration CAL est implémenté dans le système sur puce SoC pour mesurer le déphasage entre les signaux d'horloges locaux Clkl₁, Clkl₂ et Clkl₃ propagés dans chaque circuit partiel C1, C2 et C3 deux à deux et corriger la désynchronisation mesurée.

A titre indicatif, on utilise des procédés de photo-répétition de circuits partiels identiques sur une même puce pour des circuits de larges dimensions de l'ordre de quelques centimètres de largeur. Le délai de propagation d'un signal pour parcourir un circuit partiel horizontalement (noté dly) est de l'ordre de quelques dizaines de nanosecondes ce qui n'est pas négligeable pour des fréquences de fonctionnement de centaines de Mégahertz. Pour N circuits partiels adjacents ayant chacun quelques centimètres de large, les temps de propagation jusqu'au dernier circuit partiel sont multipliés par N, ainsi une désynchronisation de N x dly est observée entre le signal d'horloge local Clkl₁ du circuit partiel de rang i=1 et celui Clkl_{N} du circuit partiel de rang i=N. L'invention permet de réduire la désynchronisation à une centaine de picosecondes permettant d'améliorer la performance du système sur puce en termes de vitesse d'exécution.

Les délais de propagation selon l'axe vertical n'interviennent pas dans la désynchronisation de l'horloge car les trajets des signaux dans les circuits partiels selon cet axe présentent des différences négligeables ainsi ces délais seront exclus dans les calculs suivants par souci de simplification.

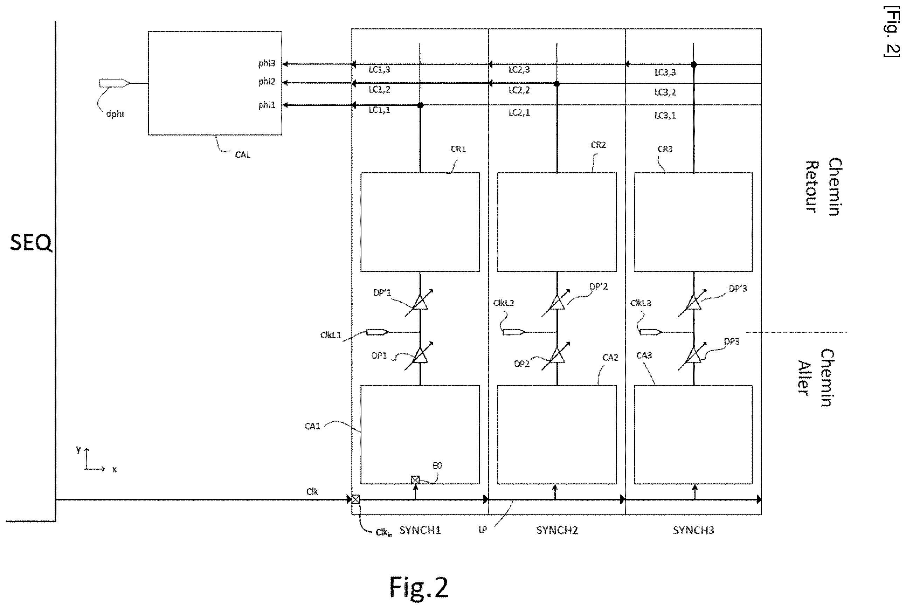

La figure 2 représente un schéma fonctionnel de l'implémentation de la solution de synchronisation du signal horloge Clk selon un premier mode de réalisation de l'invention. On se limite à la représentation de la partie utile du système SoC pour la compréhension de l'invention.

Le premier mode de réalisation décrit ci-dessous permet à l'Homme du métier de calibrer le système pour réduire la désynchronisation du signal horloge lors d'une phase de test et de validation avant la mise en marche du système. Une partie de cette calibration se fait manuellement dans ce mode de réalisation, d'où la calibration avant la mise en marche utilisant les circuits de synchronisations identiques Synch1, Synch2 et Synch3 (N=3) implémentés respectivement dans chaque circuit partiel C1, C2 et C3 en combinaison avec le circuit de calibration CAL.

Le signal d'horloge maitre Clk est généré par le circuit séquenceur SEQ et propagé aux circuits partiels adjacents photo-répétés au pied des circuits de synchronisation via une ligne conductrice principale LP. La continuité de la ligne conductrice LP est obtenue par l'abutement des différents circuits partiels identiques obtenus par photo-répétition.

Soit i un entier naturel entre 1 et N=3 ; un circuit de synchronisation de rang i SYNCHᵢ contient un premier circuit de compensation de délai CAᵢ dont l'entrée est connectée à la ligne conductrice principale LP, le premier circuit de compensation de délai établissant un premier retard de propagation entre son entrée et sa sortie Clk de valeur dlᵢ. Le circuit de compensation de délai CAᵢ est conçu de façon à obtenir un délai de propagation global entre l'entrée Clkᵢₙ recevant le signal d'horloge Clk et la sortie du circuit CAᵢ qui soit égal pour tous les circuits partiels C1, C2 et C3 en retenant l'hypothèse que la variabilité des procédés de fabrication microélectronique et le gradient de température sont négligeables. Cette solution basée sur les hypothèses détaillées ci-dessus correspond à celle proposée dans la demande de brevet EP 2 980 992.

Le tableau 1 résume les délais obtenus pour chaque circuit de compensation partiel de rang i pour N=3 avec une généralisation à la dernière ligne.

**[Tableaux 1]**

| Circuit partiel | Délai de propagation entre Clkᵢₙ et l'entrée de CAᵢ | Délai de propagation à travers CAᵢ dlᵢ | Délai global |
|---|---|---|---|
| i=1 | 0,5.dly | 2.dly | 2,5.dly |
| i=2 | 1,5.dly | dly | 2,5.dly |
| i=3 | 2,5.dly | 0 | 2,5.dly |
| ***∀i de 1 à N*** | **(i-0,5) . dly** | **(N-i).dly** | **(N-0,5).dly** |

Avec l'introduction du premier circuit de compensation de délai CAi dans chaque circuit partiel Ci, le délai de propagation global entre Clkin et la sortie de CAi est indépendant du rang i du circuit partiel et il est égal à (N-0,5) fois dly. L'effet de désynchronisation lié à la largeur des circuits photo-répétés est annulé avec l'implémentation de CAi . Cependant, la désynchronisation résultant d'une variabilité du procédé de fonctionnement ou d'un gradient de température n'est pas résolue par le premier circuit de compensation de délai CAi d'où la circuiterie supplémentaire proposée par l'invention par rapport à la solution décrite dans la demande EP 2 980 992.

Un circuit de synchronisation de rang i SYNCHᵢ contient notamment un premier composant d'insertion de délai programmable DPᵢ en série avec le premier circuit de compensation de délai CAᵢ. A la sortie du composant DPᵢ le signal d'horloge local Clklᵢ est récupéré pour piloter le fonctionnement de la globalité du circuit partiel Cᵢ à travers des connexions verticales non représentées sur la figure 2. Le composant DPᵢ est programmé à partir de la mesure du déphasage dphi détectée par le circuit de calibration CAL de façon à réduire le déphasage entre le signal d'horloge local de rang i Clklᵢ et les autres signaux d'horloge locaux. Cette insertion de délai programmable selon la mesure du déphasage détectée permet de corriger la désynchronisation entre les différents signaux d'horloges locaux Clklᵢ pour i=1 à i=N résultants de la variabilité des procédés de fabrication à travers les circuits partiels.

Pour pouvoir mesurer le déphasage dans le circuit de calibration, il est nécessaire de ramener chacun des signaux d'horloge locaux Clklᵢ aux N entrées successives du circuit de calibration CAL. Pour réaliser ce chemin de retour, on connecte un second composant d'insertion de délai programmable DP'ᵢ en série avec le premier composant d'insertion de délai programmable DP'ᵢ qui lui aussi sera programmé sur la base de la mesure du déphasage générée par le circuit de calibration CAL. A la sortie de DP'ᵢ, on connecte un second circuit de compensation de délai CRᵢ rajoutant un délai de propagation dl'ᵢ dépendant du rang du circuit partiel.

De plus, un circuit de synchronisation de rang i SYNCHᵢ, tel que représenté dans la figure 2, contient trois lignes conductrices LCᵢ₁, LCᵢ₂, LCᵢ₃ pour tout i de 1 à N=3 pour établir les connexions horizontales entre chacune des sorties des second circuits de compensation de délai CRᵢ et respectivement les entrées du circuit de calibration. Par juxtaposition entre les circuits partiels identiques, la première ligne conductrice du circuit de synchronisation d'ordre i LC_{i,1} est connectée à la première ligne conductrice du circuit de synchronisation d'ordre i+1 LC_{(i+1),1}. De même pour les deuxièmes et les troisièmes lignes conductrices. Pour généraliser, un circuit de synchronisation de rang i SYNCHᵢ contient N lignes conductrices LCᵢⱼ de rang j=1 à j=N tel que pour tout i de 1 à N, pour tout jde 1 à N : la j^{eme} ligne du i^{eme} circuit de synchronisation LCᵢⱼ est connectée à la j^{eme} ligne du (i+1)^{eme} circuit de synchronisation LCᵢⱼ.

La ligne conductrice LC_{1,1} connecte la sortie du second circuit de compensation de délai CR₁ du circuit partiel de rang i=1 avec une première entrée du circuit de calibration CAL. La combinaison des lignes conductrices LC₂₂, LC₁₃ connecte la sortie du second circuit de compensation de délai CR₂ du circuit partiel de rang i=2 avec une deuxième entrée du circuit de calibration CAL. La combinaison des lignes conductrices LC₃₃, LC₂₃, LC₁₃ connecte la sortie du second circuit de compensation de délai CR₃ du circuit partiel de rang i=3 avec une troisième entrée du circuit de calibration CAL. Pour généraliser, pour tout i de 1 à N, pour tout j de 1 à N: la sortie du second circuit de compensation de délai CRᵢ du circuit partiel de rang i est connectée à la i^{eme} entrée du circuit de calibration via la ligne conductrice LC_{i,i}.

Le circuit de calibration mesure le déphasage entre les signaux d'horloge locaux reçus sur ces N entrées deux à deux. L'Homme du métier sélectionne le couple de signaux d'horloges locaux à comparer pendant la phase de test et programme les composants d'insertion de délai programmables (DPᵢ , DP'ᵢ) correspondants aux signaux d'horloges locaux comparés pour réduire le déphasage mesuré.

Cette manipulation manuelle permet alors de résoudre la désynchronisation résultant de facteurs figés dans le temps, à savoir la différence de trajet pour atteindre les circuits partiels et la variabilité des procédés de fabrication microélectronique. L'effet du gradient de température pouvant évoluer au cours du temps n'est pas résolu avec cette implémentation nécessitant l'intervention manuelle de l'Homme du métier.

Dans un autre mode de réalisation, le délai de propagation du signal à travers le premier circuit de compensation de délai CAᵢ et le délai de propagation du signal à travers le second circuit de compensation de délai CRᵢ sont égaux. Cela permet d'annuler la composante de la désynchronisation résultante de la différence de trajets parcourus horizontalement sur le chemin de retour et récupérer à l'entrée du circuit de calibration des signaux d'horloge avec uniquement une désynchronisation résultante de la variabilité de procédés de fabrication microélectronique et le gradient de température. Cette optimisation permet d'accélérer et simplifier la mesure du déphasage dans le circuit de calibration CAL. Ainsi, le signal de mesure du déphasage dphi généré par le circuit de calibration CAL permet à l'Homme de métier de programmer les composants d'insertion de délai programmables (DPᵢ, DP'ᵢ) pour compenser le déphasage résultant de la variabilité de procédés de fabrication microélectronique dans le mode de réalisation décrit ci-dessus nécessitant une intervention manuelle de l'Homme de métier.

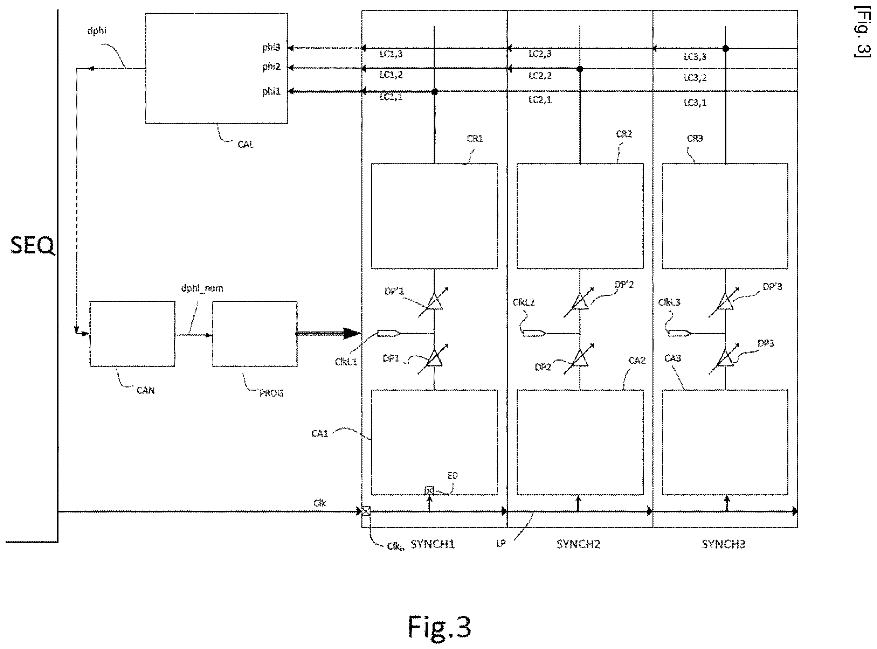

La figure 3 représente un schéma fonctionnel de l'implémentation de la solution de synchronisation du signal horloge Clk selon un second mode de réalisation. On se limite à la représentation de la partie utile du système SoC pour la compréhension de l'invention.

Le second mode de réalisation est une amélioration du premier mode de réalisation en rajoutant une boucle de rétroaction reliant le signal de mesure du déphasage à l'ensemble des composants d'insertion de délai programmables DPᵢ, DP'ᵢ. Cette boucle de rétroaction permet d'automatiser le pilotage des composants DPᵢ, DP'ᵢ pour rajouter ou soustraire des délais assurant une synchronisation entre tous les signaux d'horloge locaux Clklᵢ. Ainsi, la détection et la correction du déphasage par la solution proposée est possible en temps réel même après la mise en marche du système sur puce SoC ce qui permet de tenir en compte de l'effet désynchronisant des variations spatio-temporelles de la température dans aux environs du circuit intégré IC.

La boucle de rétroaction est réalisée en rajoutant un circuit convertisseur analogique-numérique CAN pour générer un signal numérique dphi_num transmis à un circuit de programmation PROG qui pilote les composants d'insertion de délai programmables correspondants aux couples de signaux d'horloge locaux comparés par le circuit de calibration CAL. Pour simplifier la figure, on se limite à représenter le bus reliant la sortie du circuit de programmation PROG avec le circuit intégré obtenu par photo-répétition IC pour piloter les différents composants d'insertion de délai programmables.

Le signal dphi_num est converti en une consigne de retard programmable. La calibration du circuit est réalisée selon un fonctionnement en boucle fermée. Un déphasage sensiblement nul est obtenu lorsque le système de calibration a convergé et que la consigne de retard programmable approche la valeur réelle de la désynchronisation.

L'avantage de cette implémentation comparée à l'état de l'art et au premier mode de réalisation est d'avoir une détection et correction en continu de la désynchronisation entre les signaux d'horloges locaux Clklᵢ en tenant en compte des trois sources de déphasage détaillées précédemment.

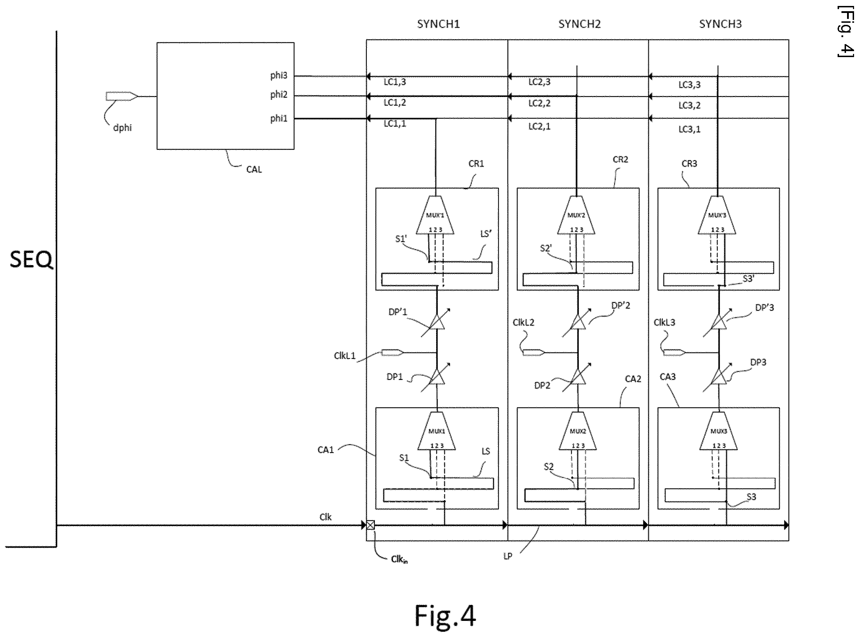

La figure 4 représente un schéma fonctionnel de l'implémentation de la solution de synchronisation du signal horloge Clk avec des détails de la réalisation des circuits de compensation de délais CAᵢ et CRᵢ. A titre d'exemple, nous allons présenter le cas où les circuits de compensation de délais CAᵢ et CRᵢ introduisent des délais dlᵢ et dl'ᵢ identiques. Dans ce cas, les deux circuits CAᵢ et CRᵢ sont identiques, nous nous limiterons à la description du circuit CAᵢ.

Un circuit de compensation de délai CAᵢ de rang i comprend une ligne conductrice notée LS avec une entrée E0 connectée verticalement à l'entrée du circuit de compensation de délai CA ᵢ et N sorties (S1, S2, S3) . La ligne conductrice est formée par un empilement de N tronçons de façon à introduire un délai de propagation égal à dly entre chaque sortie respectivement. En effet, la ligne conductrice LS est conçue pour avoir les délais de propagation suivants : délai d'E0 à S3 égal à 0, délai de S3 à S2 égal à dly et délai de S2 à S1 égal à dly. Pour généraliser pour N sorties, la ligne conductrice LS est conçue pour avoir un délai de propagation de Sⱼ vers Sⱼ₋₁ égal au délai de propagation horizontal dly à travers un circuit partiel.

Un circuit de compensation de délai CAᵢ de rang i comprend notamment un multiplexeur (MUX1, MUX2, MUX3) à N entrées de rang j = 1 à N reliées respectivement à chacune des N sorties de la première ligne conductrice de compensation LS et à une sortie reliée à la sortie du premier circuit de compensation de délai CAᵢ. Le multiplexeur MUX1 du circuit de compensation de rang 1 est programmé pour propager la sortie S1. Le multiplexeur MUX2 du circuit de compensation de rang 2 est programmé pour propager la sortie S2. Le multiplexeur MUX3 du circuit de compensation de rang 3 est programmé pour propager la sortie S3 et ainsi de suite pour N circuit partiels.

Cette implémentation permet l'obtention des délais de propagation tel que décrits dans le tableau 1.

Dans un mode de réalisation particulier, le second circuit de compensation de délai CRᵢ est identique au premier circuit de compensation de délai CAᵢ Cette implémentation présente les avantages suivants : une élimination de la désynchronisation due à la différence de trajets de propagation horizontale du signal d'horloge Clk aux chemins d'aller et de retour, une mesure du déphasage plus simple dans le circuit de calibration CAL, mais aussi une réalisation du masque de fabrication microélectronique plus simple car les circuits de compensation de délais dans un circuit partiel sont identiques.

Dans le cas où l'Homme du métier souhaite implémenter un délai de propagation différent dans le second circuit de compensation de délai CRᵢ, il suffit de moduler la largeur des N tronçons qui constituent la ligne conductrice LS du circuit CRᵢ pour modifier le délai de propagation entre les sorties successives S1, S2, S3.

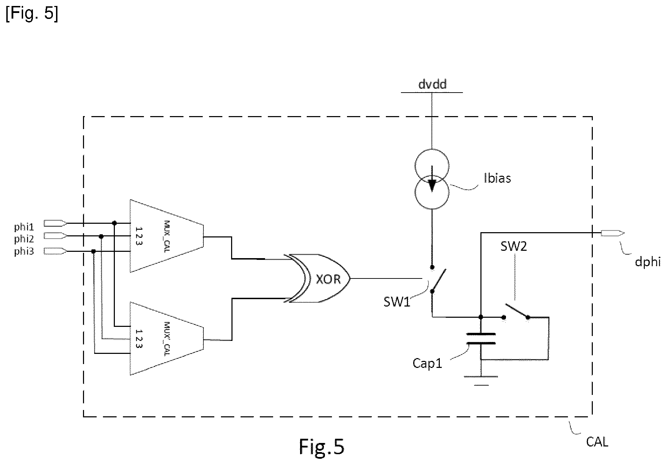

La figure 5 représente un exemple de schéma électrique du circuit de calibration CAL à N=3 entrées phi1, phi2 et phi3 et générant le signal de mesure de déphasage dphi.

Le circuit CAL comporte les éléments suivants : deux multiplexeurs MUX_CAL et MUX'_CAL à N=3 entrées chacun pour choisir le couple de signaux à comparer à partir des signaux d'horloges locaux ; un circuit logique XOR assurant la fonction OU EXCLUSIF à deux entrées reliées respectivement aux sorties des multiplexeurs de calibration MUX_CAL, MUX'_CAL ; un élément capacitif Cap1 entre la sortie du circuit logique XOR et la masse électrique, une source de courant Ibias pour alimenter le circuit de calibration CAL ; un commutateur d'activation SW1 pour contrôler la source de courant et un commutateur de réinitialisation SW2 connecté en parallèle à l'élément capacitif Cap1.

La valeur de la sortie dphi est réinitialisée en fermant le commutateur de réinitialisation SW2 et la décharge de l'élément capacitif Cap1 pendant une durée de réinitialisation.

Les signaux d'horloges à comparer sont choisis parmi les N entrées du circuit de calibration CAL via la programmation des multiplexeurs MUX_CAL et MUX'_CAL.

Suite au choix des signaux à comparer via les deux multiplexeurs, le circuit logique XOR reçoit par exemple les deux signaux déphasés phi1 et phi2. La fonction OU_EXCLUSIF génère à sa sortie un niveau logique haut tant que les deux entrées sont différentes. Ainsi, si on prend le cas où il y a un déphasage entre un front de transition de phi1 et un front de transition de phi2, la durée de l'impulsion générée par le circuit XOR est proportionnelle au déphasage entre phi1 et phi2.

Le commutateur d'activation SW1 est commandé par la sortie du circuit logique XOR. Lorsque cette sortie est à un niveau logique haut, le commutateur d'activation SW1 est fermé. L'impulsion à la sortie du circuit XOR charge ainsi l'élément capacitif CAP1 qui stocke alors le signal de la mesure du déphasage dphi. De plus, l'élément capacitif CAP1 donne la possibilité d'intégrer le déphasage sur plusieurs cycles d'horloge.

L'Homme du métier a la possibilité d'utiliser d'autres implémentations alternatives d'un circuit de calibration pour mesurer un déphasage entre deux signaux tout en restant dans le cadre de l'invention.

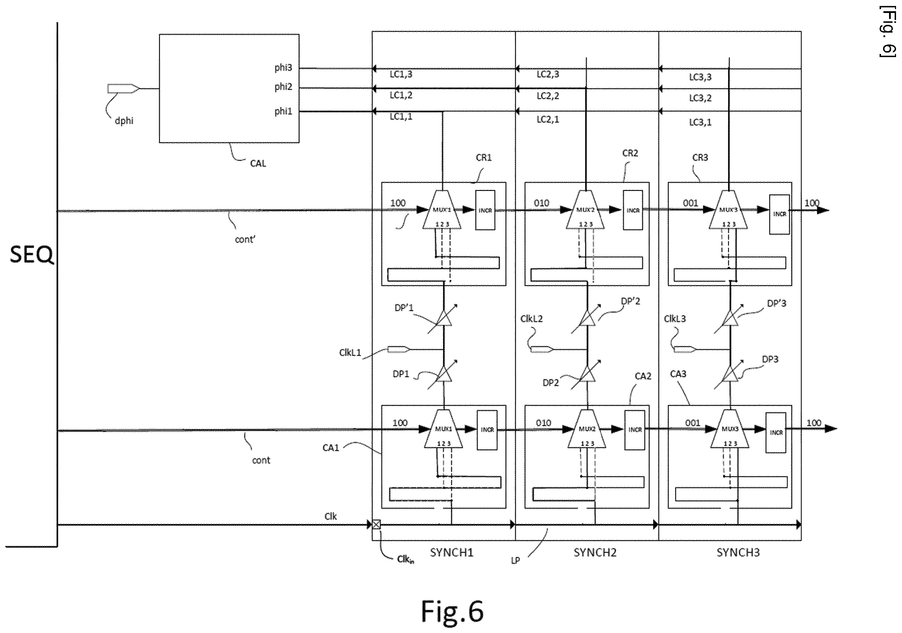

La figure 6 représente un schéma de l'implémentation de la solution de synchronisation avec un exemple de commande des multiplexeurs des circuits de synchronisation selon le premier mode de réalisation.

Pour que chaque circuit partiel de rang i sélectionne l'entrée adéquate des multiplexeurs des deux circuits de compensation de délai CAᵢ et CRᵢ, on prévoit de préférence que les multiplexeurs MUX possèdent des lignes de commande qui se propagent d'une entrée de commande cont et cont' du circuit partiel à une sortie de commande qui elle-même est reliée à l'entrée de commande du circuit partiel suivant (liaison par simple abutement des motifs des circuits partiels juxtaposés) ; mais cette propagation se fait à chaque fois en incrémentant le rang de l'entrée sélectionnée. En d'autres mots, le signal de commande propagé est légèrement différent du signal de commande reçu, mais la différence (incrémentation d'une unité) est la même pour tous les circuits partiels. Ainsi, bien que les circuits partiels et notamment l'organisation des lignes de commande soit exactement la même d'un circuit au suivant (incluant le circuit permettant l'incrémentation) on commande le multiplexeur du circuit partiel de rang i différemment du circuit partiel suivant.

Sur la figure 6, les lignes de commande associées au multiplexeur (MUXᵢ, MUX'ᵢ) du circuit partiel de rang i reçoivent un signal de contrôle (cont ou cont') de N-bits dans lequel le i^{ème} bit est au niveau logique actif 1 est les autres bits sont à 0. Un circuit d'incrémentation d'une unité, désigné par INCR, est alors inséré entre les lignes de commande arrivant au multiplexeur et les sorties de commande destinées au circuit partiel suivant pour incrémenter la position du bit au niveau logique actif 1.

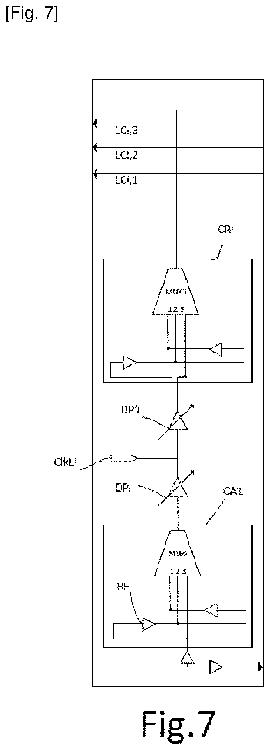

La figure 7 représente un schéma électrique d'un circuit de synchronisation partiel SYNCHᵢ incluant des amplificateurs tampons identiques BF entre les sorties successives des lignes conductrices LS et LS' des circuits de compensation de délai CAᵢ et CRᵢ. Ces amplificateurs tampons servent à préserver la qualité des signaux propagés à travers les circuits partiels.

En guise de conclusion, l'invention décrite permet d'implémenter un système sur puce incluant un circuit intégré obtenu par photo-répétitions de circuits partiels identiques présentant certaines caractéristiques spécifiques. Le circuit intégré obtenu par photo-répétitions selon l'invention présente des avantages techniques par rapport à l'état de l'art permettant la réduction de la désynchronisation des signaux de d'horloge (ou généralement de commande) gérant le fonctionnement des différents circuits partiels photo-répétés en tenant en compte des différentes sources de cette désynchronisation à savoir les larges dimensions de ce type de circuit, la variabilité des procédés de fabrication microélectronique et le gradient de la température aux environs du circuit. L'Homme du métier peut concevoir les différents circuits utilisés pour réaliser les fonctions décrites dans les différents modes de réalisation de l'invention qu'il soit le mode automatisé pendant le fonctionnement du système ou le mode manuel pendant une phase de validation avant la mise en marche du système.

## Revendications

1. Système sur puce (SoC) comprenant :
un circuit (IC) formé de N motifs adjacents tous identiques correspondant à N circuits partiels identiques adjacents (C1, C2, C3) de rang i = 1 à i = N dans l'ordre de succession des circuits partiels, le circuit intégré (IC) nécessitant pour son fonctionnement un signal maître (CLK) reçu sur un circuit partiel de rang 1 et transmis en cascade d'un circuit partiel de rang i au circuit partiel de rang i+1 par une ligne conductrice principale (LP) dans chaque circuit partiel, chaque circuit partiel de rang i comprenant :
- un premier circuit de compensation de délai (CA1, CA2, CA3) dont l'entrée est connectée à la ligne conductrice principale (LP), le premier circuit de compensation de délai établissant un premier retard de propagation entre son entrée et sa sortie ;
- un premier composant d'insertion de délai programmable (DP1, DP2, DP3) en série avec le premier circuit de compensation de délai ;
- un second composant d'insertion de délai programmable (DP'1, DP'2, DP'3) en série avec le premier composant d'insertion de délai programmable (DP1, DP2, DP3) ;
- un second circuit de compensation de délai (CR1, CR2, CR3) connecté à la sortie du second composant d'insertion de délai programmable (DP'1, DP'2, DP'3), le second circuit de compensation de délai établissant un second retard de propagation entre son entrée et sa sortie ;
- N lignes conductrices (LC1,1 ; LC1,2 ; LC1,3) de rang j=1 à j=N tel que la ligne de rang j du circuit partiel de rang i est connectée à la ligne de rang j du circuit partiel de rang i+1,
la ligne conductrice de rang j=i du circuit partiel de rang i étant connectée à la sortie du second circuit de compensation de délai du circuit partiel de rang i,
le circuit intégré (IC) comprenant en outre un circuit de calibration (CAL) à N entrées reliées respectivement aux N lignes conductrices, configuré pour générer un signal (dphi) de mesure du déphasage entre chaque couple de signaux reçus sur deux entrées respectives du circuit de calibration (CAL), le signal de mesure étant destiné à piloter chaque composant d'insertion de délai programmable (DP1, DP2, DP3, DP'1, DP'2, DP'3) de chaque circuit partiel,
la sortie du premier composant d'insertion de délai programmable du circuit partiel de rang i fournissant ainsi un signal local (ClkL1, ClkL2, ClkL3) pour ce circuit partiel.

2. Système sur puce (SoC) selon la revendication 1, dans lequel le signal maître (Clk) est un signal d'horloge général et le signal local (ClkL1, ClkL2, ClkL3) issu du premier composant d'insertion de délai programmable (DP1, DP2, DP3) de rang i est un signal d'horloge locale pour le circuit partiel de rang i.

3. Système sur puce (SoC) selon l'une quelconque des revendications précédentes, dans lequel le délai de propagation à travers le premier circuit de compensation de délai (CA1, CA2, CA3) est égal au délai de propagation à travers le second circuit de compensation de délai (CR1, CR2, CR3).

4. Système sur puce (SoC) selon l'une quelconque des revendications précédentes comprenant un convertisseur analogique-numérique (CAN) pour convertir le signal de mesure de déphasage (dphi) en signal numérique (dphi_num) et un circuit de programmation (PROG) connecté à la sortie du convertisseur analogique-numérique (CAN) pour commander les composants d'insertion de délai programmables dans chaque circuit partiel de rang i.

5. Système sur puce (SoC) selon l'une quelconque des revendications précédentes, dans lequel le circuit de calibration (CAL) comprend :
un premier multiplexeur de calibration (MUX_CAL) à N entrées reliées respectivement aux N entrées du circuit de calibration,
un second multiplexeur de calibration (MUX'_CAL) à N entrées reliées respectivement aux N entrées du circuit de calibration,
un circuit logique (XOR) assurant la fonction OU EXCLUSIF à deux entrées reliées respectivement aux sorties des multiplexeurs de calibration (MUX_CAL, MUX'_CAL),
un élément capacitif (Cap1) entre la sortie du circuit logique (XOR) et la masse électrique,
une source de courant (Ibias) pour alimenter le circuit de calibration (CAL),
un commutateur d'activation (SW1) contrôlé par la sortie du circuit logique (XOR),
un commutateur de réinitialisation (SW2) connecté en parallèle à l'élément capacitif (Cap1).

6. Système sur puce (SoC) selon l'une quelconque des revendications précédentes dans lequel
le premier circuit de compensation de délai (CA1, CA2, CA3) d'un circuit partiel de rang i comprend :
une première ligne conductrice de compensation (LS) à N sorties successives (S1 ; S2 ; S3) de rang j = 1 à N, reliée à la ligne principale (LP)
un premier multiplexeur (MUX1, MUX2, MUX3) à N entrées de rang j = 1 à N reliées respectivement à chacune des N sorties de la première ligne conductrice de compensation (LS) et à une sortie reliée à la sortie du premier circuit de compensation de délai (CA1, CA2, CA3),
le second circuit de compensation de délai (CR1, CR2, CR3) d'un circuit partiel de rang i comprend :
une seconde ligne conductrice de compensation (LS') à N sorties successives (S'1 ; S'2 ; S'3) de rang j = 1 à N, reliée à la sortie du second composant d'insertion de délai programmable (DP'1, DP'2, DP'3),
un second multiplexeur (MUX'1, MUX'2, MUX'3) à N entrées de rang j = 1 à N reliées respectivement à chacune des N sorties de la seconde ligne conductrice de compensation (LS') et à une sortie reliée à la sortie du second circuit de compensation de délai (CR1, CR2, CR3).

7. Système sur puce (SoC) selon la revendication 6, dans lequel
le premier multiplexeur (MUX1, MUX2, MUX3) du circuit partiel de rang i est configuré pour sélectionner la sortie de rang j=i parmi les N sorties de la première ligne de compensation (LS) à partir d'un premier signal de contrôle (cont),
le second multiplexeur (MUX'1, MUX'2, MUX'3) du circuit partiel de rang i est configuré pour sélectionner la sortie de rang i parmi les N sorties de la seconde ligne de compensation (LS') à partir d'un second signal de contrôle (cont').

8. Système sur puce (SoC) selon l'une des revendications 6 ou 7, dans lequel
au moins un amplificateur tampon (BF) est inséré dans la ligne principale (LP),
un amplificateur tampon identique (BF) respectif est inséré dans la première ligne de compensation de délai (LS) entre chacune de ses sorties et la sortie de rang immédiatement suivant de la ligne,
un amplificateur tampon identique (BF) respectif est inséré dans la seconde ligne de compensation de délai (LS') entre chacune de ses sorties et la sortie de rang immédiatement suivant de la ligne.

9. Système sur puce (SoC) selon l'une quelconque des revendications 6 à 8 comprenant dans chaque circuit partiel de rang i un circuit d'incrémentation d'une unité (INCR) pour recevoir les signaux de contrôle (cont ,cont') des circuits multiplexeurs (MUX1, MUX'1, MUX2, MUX'2, MUX3, MUX'3) du circuit partiel de rang i, incrémenter d'une unité le rang de l'entrée sélectionnée et propager le signal de commande incrémenté vers les circuits multiplexeurs (MUX1, MUX'1, MUX2, MUX'2, MUX3, MUX'3) du circuit partiel de rang i+1.

10. Système sur puce (SoC) selon l'une quelconque des revendications précédentes, dans lequel les circuits partiels identiques adjacents (C1, C2, C3) sont réalisés au moyen d'une succession d'expositions photo-lithographiques d'un même masque, décalées spatialement.

## Patentansprüche

1. Ein-Chip-System (SoC), umfassend:
eine Schaltung (IC), die aus N benachbarten Mustern gebildet ist, die jeweils identisch sind, entsprechend N benachbarten identischen Teilschaltungen (C1, C2, C3) der Ordnung i = 1 bis i = N im Ordnungsprinzip der Teilschaltungen, wobei die integrierte Schaltung (IC) für ihren Betrieb ein Master-Signal (CLK) benötigt, das auf einer Teilschaltung der Ordnung 1 empfangen und in einer Kaskade über eine leitfähige Hauptleitung (LP) von einer Teilschaltung der Ordnung i an die Teilschaltung der Ordnung i+1 in jeder Teilschaltung übertragen wird, wobei jede Teilschaltung der Ordnung i Folgendes umfasst:
- eine erste Verzögerungsausgleichsschaltung (CA1, CA2, CA3), deren Eingang mit der leitfähigen Hauptleitung (LP) verbunden ist, wobei die erste Verzögerungsausgleichsschaltung einen ersten Ausbreitungsverzug zwischen ihrem Eingang und ihrem Ausgang erzeugt;
- eine erste programmierbare Komponente zum Einführen einer Verzögerung (DP1, DP2, DP3) in Reihe mit der ersten Verzögerungsausgleichsschaltung;
- eine zweite programmierbare Komponente zum Einführen einer Verzögerung (DP'1, DP'2, DP'3) in Reihe mit der ersten programmierbaren Komponente zum Einführen einer Verzögerung (DP1, DP2, DP3);
- eine zweite Verzögerungsausgleichsschaltung (CR1, CR2, CR3), die mit dem Ausgang der zweiten programmierbaren Komponente zum Einführen einer Verzögerung (DP'1, DP'2, DP'3) verbunden ist, wobei die zweite Verzögerungsausgleichsschaltung einen zweiten Ausbreitungsverzug zwischen ihrem Eingang und ihrem Ausgang erzeugt;
- N leitfähige Leitungen (LC1,1; LC1,2; LC1,3) der Ordnung j=1 bis j=N, so dass die Leitung der Ordnung j der Teilschaltung der Ordnung i mit der Leitung der Ordnung j der Teilschaltung der Ordnung i+1 verbunden ist,
wobei die leitfähige Leitung der Ordnung j=i der Teilschaltung der Ordnung i mit dem Ausgang der zweiten Verzögerungsausgleichsschaltung der Teilschaltung der Ordnung i verbunden ist,
wobei die integrierte Schaltung (IC) ferner eine Kalibrierschaltung (CAL) mit N Eingängen, die jeweils mit den N leitfähigen Leitungen verknüpft sind, umfasst, die dafür konfiguriert ist, ein Phasendifferenz-Messsignal (dphi) zwischen jedem an zwei jeweiligen Eingängen der Kalibrierschaltung (CAL) empfangenen Signalpaar zu erzeugen, wobei das Messsignal dazu gedacht ist, jede programmierbare Komponente zum Einführen einer Verzögerung (DP1, DP2, DP3, DP'1, DP'2, DP'3) jeder Teilschaltung anzutreiben,
wobei der Ausgang der ersten programmierbaren Komponente zum Einführen einer Verzögerung der Teilschaltung der Ordnung i somit ein lokales Signal (ClkL1, ClkL2, ClkL3) für diese Teilschaltung liefert.

2. Ein-Chip-System (SoC) nach Anspruch 1, wobei das Master-Signal (Clk) ein allgemeines Taktsignal ist und das lokale Signal (ClkL1, ClkL2, ClkL3), das aus der ersten programmierbaren Komponente zum Einführen einer Verzögerung (DP1, DP2, DP3) der Ordnung i ausgegeben wird, ein lokales Taktsignal für die Teilschaltung der Ordnung i ist.

3. Ein-Chip-System (SoC) nach einem der vorhergehenden Ansprüche, wobei die Ausbreitungsverzögerung über die erste Verzögerungsausgleichsschaltung (CA1, CA2, CA3) gleich der Ausbreitungsverzögerung über die zweite Verzögerungsausgleichsschaltung (CR1, CR2, CR3) ist.

4. Ein-Chip-System (SoC) nach einem der vorhergehenden Ansprüche, umfassend einen Analog-Digitalwandler (CAN) zum Umwandeln des Phasendifferenz-Messsignals (dphi) in ein digitales Signal (dphi_num) und eine Programmierschaltung (PROG), die mit dem Ausgang des Analog-Digitalwandlers (CAN) verbunden ist, um die programmierbaren Komponenten zum Einführen einer Verzögerung in jeder Teilschaltung der Ordnung i zu steuern.

5. Ein-Chip-System (SoC) nach einem der vorhergehenden Ansprüche, wobei die Kalibrierschaltung (CAL) Folgendes umfasst:
einen ersten Kalibriermultiplexer (MUX_CAL) mit N Eingängen, die jeweils mit den N Eingängen der Kalibrierschaltung verknüpft sind,
einen zweiten Kalibriermultiplexer (MUX'_CAL) mit N Eingängen, die jeweils mit den N Eingängen der Kalibrierschaltung verknüpft sind,
eine logische Schaltung (XOR), die die Funktion EXKLUSIVES ODER an zwei Eingängen bereitstellt, die jeweils mit den Ausgängen der Kalibriermultiplexer (MUX_CAL, MUX'_CAL) verknüpft sind,
ein kapazitives Element (Cap1) zwischen dem Ausgang der logischen Schaltung (XOR) und der elektrischen Masse,
eine Stromquelle (Ibias) zum Versorgen der Kalibrierschaltung (CAL),
einen Aktivierungsschalter (SW1), der von dem Ausgang der logischen Schaltung (XOR) geregelt wird,
einen Reinitialisierungsschalter (SW2), der parallel mit dem kapazitiven Element (Cap1) verbunden ist.

6. Ein-Chip-System (SoC) nach einem der vorhergehenden Ansprüche, wobei
die erste Verzögerungsausgleichsschaltung (CA1, CA2, CA3) einer Teilschaltung der Ordnung i Folgendes umfasst:
eine erste leitfähige Ausgleichsleitung (LS) mit N aufeinanderfolgenden Ausgängen (S1; S2; S3) der Ordnung j = 1 bis N, die mit der Hauptleitung (LP) verknüpft ist,
einen ersten Multiplexer (MUX1, MUX2, MUX3) mit N Eingängen der Ordnung j = 1 bis N, die jeweils mit jedem der N Ausgänge der ersten leitfähigen Ausgleichsleitung (LS) und einem Ausgang verknüpft ist, der mit dem Ausgang der ersten Verzögerungsausgleichsschaltung (CA1, CA2, CA3) verknüpft ist,
wobei die zweite Verzögerungsausgleichsschaltung (CR1, CR2, CR3) einer Teilschaltung der Ordnung i Folgendes umfasst:
eine zweite leitfähige Ausgleichsschaltung (LS') mit N aufeinanderfolgenden Ausgängen (S'1; S'2; S'3) der Ordnung j = 1 bis N, die mit dem Ausgang der zweiten programmierbaren Komponente zum Einführen einer Verzögerung (DP'1, DP'2, DP'3) verknüpft ist,
einen zweiten Multiplexer (MUX'1, MUX'2, MUX'3) mit N Eingängen der Ordnung j = 1 bis N, die jeweils mit jedem der N Ausgänge der zweiten leitfähigen Ausgleichsleitung (LS') und einem Ausgang verknüpft ist, der mit dem Ausgang der zweiten Verzögerungsausgleichsschaltung (CR1, CR2, CR3) verknüpft ist.

7. Ein-Chip-System (SoC) nach Anspruch 6, wobei
der erste Multiplexer (MUX1, MUX2, MUX3) der Teilschaltung der Ordnung i dafür konfiguriert ist, den Ausgang der Ordnung j=i aus den N Ausgängen der ersten Ausgleichsleitung (LS) anhand eines ersten Regelsignals (cont) auszuwählen,
der zweite Multiplexer (MUX' 1, MUX'2, MUX'3) der Teilschaltung der Ordnung i dafür konfiguriert ist, den Ausgang der Ordnung i aus den N Ausgängen der zweiten Ausgleichsleitung (LS') anhand eines zweiten Regelsignals (cont') auszuwählen.

8. Ein-Chip-System (SoC) nach Anspruch 6 oder 7, wobei
mindestens ein Trennverstärker (BF) in die Hauptleitung (LP) eingefügt ist,
ein jeweiliger identischer Trennverstärker (BF) in die erste Verzögerungsausgleichsleitung (LS) zwischen jedem seiner Ausgänge und dem Ausgang der unmittelbar folgenden Ordnung der Leitung eingeführt ist,
ein jeweiliger identischer Trennverstärker (BF) in die zweite Verzögerungsausgleichsleitung (LS') zwischen jedem seiner Ausgänge und dem Ausgang der unmittelbar folgenden Ordnung der Leitung eingeführt ist.

9. Ein-Chip-System (SoC) nach einem der Ansprüche 6 bis 8, umfassend in jeder Teilschaltung der Ordnung i eine Schaltung zum Erhöhen um eine Einheit (INCR) zum Empfangen der Regelsignale (cont, cont') der Multiplexerschaltungen (MUX1, MUX' 1, MUX2, MUX'2, MUX3, MUX'3) der Teilschaltung der Ordnung i, Erhöhen des ausgewählten Eingangs um eine Einheit der Ordnung und Ausbreiten des erhöhten Steuersignals auf die Multiplexerschaltungen (MUX1, MUX'1, MUX2, MUX'2, MUX3, MUX'3) der Teilschaltung der Ordnung i+1.

10. Ein-Chip-System (SoC) nach einem der vorhergehenden Ansprüche, wobei die benachbarten identischen Teilschaltungen (C1, C2, C3) mittels einer Folge von räumlich versetzten photolithographischen Belichtungen ein und derselben Maske hergestellt sind.

## Claims

1. A system-on-a-chip (SoC) comprising:
a circuit (IC) formed by N adjacent patterns that are all identical and correspond to N adjacent identical partial circuits (C1, C2, C3) of rank i = 1 to i = N in the order of succession of the partial circuits, the integrated circuit (IC) requiring a master signal (CLK) in order to operate, which is received on a partial circuit of rank 1 and transmitted as a cascade from a partial circuit of rank i to the partial circuit of rank i +1 by a main conductive line (LP) in each partial circuit, with each partial circuit of rank i comprising:
- a first delay compensation circuit (CA1, CA2, CA3), the input of which is connected to the main conductive line (LP), the first delay compensation circuit establishing a first propagation delay between its input and its output;
- a first programmable delay insertion component (DP1, DP2, DP3) in series with the first delay compensation circuit;
- a second programmable delay insertion component (DP'1, DP'2, DP'3) in series with the first programmable delay insertion component (DP1, DP2, DP3);
- a second delay compensation circuit (CR1, CR2, CR3) connected to the output of the second programmable delay insertion component (DP'1, DP'2, DP'3), the second delay compensation circuit establishing a second propagation delay between its input and its output;
- N conductive lines (LC1, 1; LC1, 2; LC1, 3) of rank j = 1 to j = N, such that the line of rank j of the partial circuit of rank i is connected to the line of rank j of the partial circuit of rank i +1;
the conductive line of rank j = i of the partial circuit of rank i being connected to the output of the second delay compensation circuit of the partial circuit of rank i;
the integrated circuit (IC) further comprising a calibration circuit (CAL) with N inputs respectively linked to the N conductive lines, configured to generate a signal (dphi) for measuring the phase shift between each pair of signals received on two respective inputs of the calibration circuit (CAL), the measurement signal being intended to drive each programmable delay insertion component (DP1, DP2, DP3, DP'1, DP'2, DP'3) of each partial circuit;
the output of the first programmable delay insertion component of the partial circuit of rank i thereby providing a local signal (ClkL1, ClkL2, ClkL3) for this partial circuit.

2. The system-on-a-chip (SoC) according to claim 1, wherein the master signal (Clk) is a general clock signal and the local signal (ClkL1, ClkL2, ClkL3) originating from the first programmable delay insertion component (DP1, DP2, DP3) of rank i is a local clock signal for the partial circuit of rank i.

3. The system-on-a-chip (SoC) according to any one of the preceding claims, wherein the propagation delay through the first delay compensation circuit (CA1, CA2, CA3) is equal to the propagation delay through the second delay compensation circuit (CR1, CR2, CR3).

4. The system-on-a-chip (SoC) according to any one of the preceding claims, comprising an analogue-to-digital converter (CAN) for converting the phase shift measurement signal (dphi) into a digital signal (dphi_num) and a programming circuit (PROG) connected to the output of the analogue-to-digital converter (CAN) for controlling the programmable delay insertion components in each partial circuit of rank i.

5. The system-on-a-chip (SoC) according to any one of the preceding claims, wherein the calibration circuit (CAL) comprises:
a first calibration multiplexer (MUX_CAL) with N inputs respectively linked to the N inputs of the calibration circuit;
a second calibration multiplexer (MUX'_CAL) with N inputs respectively linked to the N inputs of the calibration circuit;
a logic circuit (XOR) providing the EXCLUSIVE OR function to two inputs respectively linked to the outputs of the calibration multiplexers (MUX_CAL, MUX'_CAL);
a capacitive element (Cap1) between the output of the logic circuit (XOR) and the electrical ground;
a current source (Ibias) for powering the calibration circuit (CAL);
an activation switch (SW1) regulated by the output of the logic circuit (XOR);
a reset switch (SW2) connected in parallel to the capacitive element (Cap1).

6. The system-on-a-chip (SoC) according to any one of the preceding claims, wherein
the first delay compensation circuit (CA1, CA2, CA3) of a partial circuit of rank i comprises:
a first compensation conductive line (LS) with N successive outputs (S1; S2; S3) of rank j = 1 to N, linked to the main line (LP);
a first multiplexer (MUX1, MUX2, MUX3) with N inputs of rank j = 1 to N respectively linked to each of the N outputs of the first conductive compensation line (LS) and to an output linked to the output of the first delay compensation circuit (CA1, CA2, CA3);
the second delay compensation circuit (CR1, CR2, CR3) of a partial circuit of rank i comprises:
a second conductive compensation line (LS') with N successive outputs (S'1; S'2; S'3) of rank j = 1 to N, linked to the output of the second programmable delay insertion component (DP'1, DP'2, DP'3);
a second multiplexer (MUX'1, MUX'2, MUX'3) with N inputs of rank j = 1 to N respectively linked to each of the N outputs of the second conductive compensation line (LS') and to an output linked to the output of the second delay compensation circuit (CR1, CR2, CR3).

7. The system-on-a-chip (SoC) according to claim 6, wherein
the first multiplexer (MUX1, MUX2, MUX3) of the partial circuit of rank i is configured to select the output of rank j = i from among the N outputs of the first compensation line (LS) from a first regulation signal (cont);
the second multiplexer (MUX' 1, MUX'2, MUX'3) of the partial circuit of rank i is configured to select the output of rank i from among the N outputs of the second compensation line (LS') from a second regulation signal (cont').

8. The system-on-a-chip (SoC) according to any of claims 6 or 7, wherein
at least one buffer amplifier (BF) is inserted in the main line (LP),
a respective identical buffer amplifier (BF) is inserted in the first delay compensation line (LS) between each of its outputs and the output of the line with an immediately following rank,
a respective identical buffer amplifier (BF) is inserted in the second delay compensation line (LS') between each of its outputs and the output of the line with an immediately following rank.

9. The system-on-a-chip (SoC) according to any one of claims 6 to 8, comprising, in each partial circuit of rank i, a circuit for incrementing by one unit (INCR) for receiving the regulation signals (cont, cont') of the multiplexer circuits (MUX1, MUX'1, MUX2, MUX'2, MUX3, MUX'3) of the partial circuit of rank i, for incrementing the rank of the selected input by one unit and for propagating the incremented control signal to the multiplexer circuits (MUX1, MUX'1, MUX2, MUX'2, MUX3, MUX'3) of the partial circuit of rank i +1.

10. The system-on-a-chip (SoC) according to any one of the preceding claims, wherein the adjacent identical partial circuits (C1, C2, C3) are produced by means of a succession of spatially offset photo-lithographic exposures of one and the same mask.
